Europäisches Patentamt

European Patent Office

Office européen des brevets

(19)

(11) **EP 1 708 301 A1**

(12) **EUROPEAN PATENT APPLICATION**
published in accordance with Art. 158(3) EPC

(43) Date of publication:
**04.10.2006 Bulletin 2006/40**

(21) Application number: **04799495.9**

(22) Date of filing: **04.11.2004**

(51) Int Cl.:
*H01M 14/00* (2006.01)    *H01L 31/04* (2006.01)

(86) International application number:
**PCT/JP2004/016316**

(87) International publication number:
**WO 2005/053081 (09.06.2005 Gazette 2005/23)**

(84) Designated Contracting States:
**DE ES FR IT NL**

(30) Priority: **25.11.2003 JP 2003394785**

(71) Applicant: **NGK Spark Plug Co., Ltd.**
**Nagoya-shi,**
**Aichi 467-8525 (JP)**

(72) Inventors:
• **GONDA, Ichiro**
c/o NGK SPARK PLUG CO., LTD.
**Nagoya-shi,**
**Aichi 467-8525 (JP)**

• **OKUYAMA, Yasuo**
c/o NGK SPARK PLUG CO., LTD.
**Nagoya-shi,**
**Aichi 467-8525 (JP)**

(74) Representative: **Grünecker, Kinkeldey,**
**Stockmair & Schwanhäusser**
**Anwaltssozietät**
**Maximilianstrasse 58**
**80538 München (DE)**

(54) **DYE-SENSITIZED SOLAR CELL**

(57)    According to an aspect of the present invention, there is provided a dye-sensitized solar cell including: a first substrate having a light-transmitting property; a semiconductor electrode containing a sensitizing dye and arranged with a first surface thereof facing the first substrate; a first collector electrode arranged on a second surface of the semiconductor electrode; an insulating layer arranged in contact with the first collector electrode; a catalytic electrode layer arranged with a first surface thereof facing the insulating layer; a second substrate arranged on a second surface of the catalytic electrode layer; and an electrolyte material incorporated in the semiconductor electrode, the first collector electrode and the insulating layer. This dye-sensitized solar cell becomes lower in internal resistance without the need to provide a light-transmitting collector electrode and the like to the light-transmitting first substrate on the light incident side.

## FIG.1

EP 1 708 301 A1

## Description

Technical Field

The present invention relates to a dye-sensitized solar cell for directly converting light energy into electrical energy, in particular, of the type having a lower internal resistance without the need to provide a light-transmitting collector electrode and the like to a light-transmitting substrate on the light incident side.

Background Art

Solar cells utilizing single-crystal silicon, polycrystalline silicon, amorphous silicon, HIT (Heterojunction with Intrinsic Thin-layer) formed by varying combinations thereof have currently been put to practical use and become major techniques in solar power generation technology. These silicon solar cells show excellent photoelectric conversion efficiencies of nearly 20%, but require high energy costs for material processing and have many problems to be addressed such as environmental burdens and cost and material supply limitations.

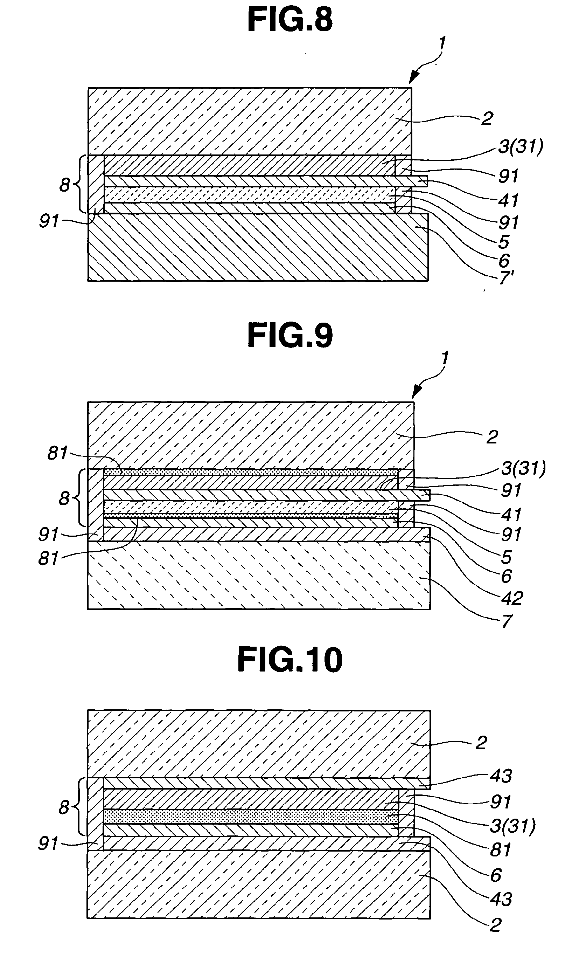

On the other hand, dye-sensitized solar cells have been proposed by Gratzel et al. in Japanese Laid-Open Patent Publication No. Hei-01-220380 and Nature (vol. 353, pp.737-740, 1991) and come to attention as low-priced solar cells. This type of solar cell is provided with a porous titania semiconductor electrode 3 supporting thereon a sensitizing dye 31, a counter electrode 6 and an electrolytic layer 81 interposed between the semiconductor electrode 3 and the counter electrode 6, as shown in FIG. 10, to allow significant reductions in material and processing cost although being lower in photoelectric conversion efficiency than the currently available silicon solar cell.

However, the semiconductor electrode 3 is arranged on a light-transmitting substrate 2 with a transparent conductive film 43, which functions as a light-transmitting collector electrode, being interposed between the light-transmitting substrate 2 and the semiconductor electrode 3. The transparent conductive film 43 has a higher resistance than that of a metallic film. The arrangement of such a transparent conductive film 43 causes an increase in cell internal resistance to produce a substantial voltage drop even by the development of a slight electric current. Further, the transparent conductive film 43 is generally applied to the light-transmitting substrate 2 by sputtering etc. so that it takes time and effort in the manufacturing of the dye-sensitized solar cell. The arrangement of the transparent conductive film 43 also causes a decrease in light transmissivity to reduce the amount of light reaching the semiconductor electrode 3 and result in a lowering of photoelectric conversion efficiency.

Disclosure of the Invention

The present invention has been made to solve the above problems and aims to provide a dye-sensitized solar cell capable of securing a lower internal resistance without the need to attach a light-transmitting collector electrode and the like to a light-transmitting substrate on the light incident side.

According to an aspect of the present invention, there is provided a dye-sensitized solar cell, comprising: a first substrate having a light-transmitting property; a semiconductor electrode containing a sensitizing dye and arranged in such a manner that a first surface of the semiconductor electrode faces the first substrate; a first collector electrode arranged on a second surface of the semiconductor electrode; an insulating layer arranged in contact with the first collector electrode; a catalytic electrode layer arranged in such a manner that a first surface of the catalytic electrode layer faces the insulating layer; a second substrate arranged on a second surface of the catalytic electrode layer; and an electrolyte material incorporated in the semiconductor electrode, the first collector electrode and the insulating layer.

Brief Description of Drawings

FIG. 1 is a sectional view of a dye-sensitized solar cell according to one preferred embodiment of the present invention.

FIG. 2 is a schematic view of a semiconductor electrode of the dye-sensitized solar cell.
FIG. 3 is a schematic view of the dye-sensitized solar cell, when having a collector electrode partly embedded in the semiconductor electrode.
FIG. 4 is a schematic view showing one example of grid electrode pattern of collector electrode arrangement.
FIG. 5 is a schematic view showing one example of comb electrode pattern of collector electrode arrangement.
FIG. 6 is a schematic view showing one example of radial electrode pattern of collector electrode arrangement.
FIG. 7 is a schematic view of the dye-sensitized solar cell, when having a catalytic electrode layer used as a positive terminal.
FIG. 8 is a schematic view of the dye-sensitized solar cell, when having a substrate used as a positive terminal.

FIG. 9 is a schematic view of the dye-sensitized solar cell, when provided with an electrolyte material layer.
FIG. 10 is a schematic view of a dye-sensitized solar cell according to the earlier technology.

Best Mode for Carrying Out the Invention

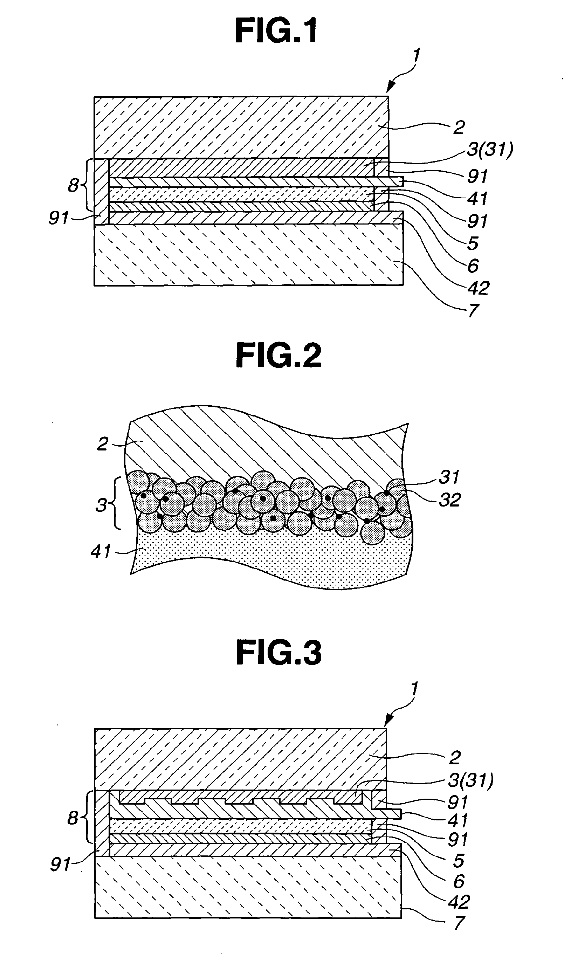

Hereinafter, one preferred embodiment of the present invention will be described below in detail with reference to FIGS. 1 to 10.

A dye-sensitized solar cell 1 according to one embodiment of the present invention includes a light-transmitting substrate 2, a semiconductor electrode 3, a first collector electrode 41, an insulating layer 5, a catalytic electrode layer 6, a substrate 7 (7') and an electrolyte material 8 as shown in FIG. 1.

The light-transmitting substrate 2 is not particularly restricted as long as it shows a light-transmitting property in a wavelength range where photoelectric power generation is possible. The material of the light-transmitting substrate 2 can be selected as appropriate. As the light-transmitting substrate 2, there may be used a sheetsubstrate of glass, resin, ceramic or the like. The kind of the glass is not particularly restricted. Examples of the glass include soda glass, borosilicate glass, aluminosilicate glass, aluminoborosilicate glass, silica glass and soda-lime glass. The kind of the resin is not particularly restricted. Examples of the resin sheet include sheets of polyesters such as polyethylene terephthalate and polyethylene naphthalate and other sheets of polyphenylene sulfides, polycarbonates, polysulfones and polyethylidene norbornenes. The kind of the ceramic is not also restricted. Examples of the ceramic include high purity alumina.

The light-transmitting substrate 2 varies in thickness depending on the material thereof. The thickness of the light-transmitting substrate 2 is not particularly restricted but is desirably of such a thickness that the substrate 2 is capable of maintaining its light-transmitting property.

Herein, the light-transmitting property means that the transmissivity of visible light having a wavelength of 400 to 900 nm as expressed by the following equation is 10% or higher. The light transmissivity is preferably in a range of 60% or higher, more preferably 85% or higher. The meaning of the light-transmitting property and the desirable range of the light transmissivity are hereinafter the same throughout the description.

$$\text{Transmissivity (\%)} = (\text{the amount of transmitted light / the amount of incident light}) \times 100$$

The semiconductor electrode 3 is arranged with a first surface thereof facing the light-transmitting substrate 2 and has a sensitizing dye 31 and a electrode body 32 made of a semiconductor material as shown in FIG. 2. The semiconductor electrode 3 may or may not be in contact with the light-transmitting substrate 2.

As the sensitizing dye 31, there may be used a complex dye or an organic dye for improved photoelectric conversion. Examples of the complex dye include metal complex dyes. Examples of the organic dye include polymethine dyes and merocyanine dyes. Specific examples of the metal complex dyes include ruthenium complex dyes and osmium complex dyes. Among others, especially preferred are ruthenium complex dyes. In order to extend the photoelectric conversion wavelength range of the sensitizing dye and thereby obtain an improvement in photoelectric conversion efficiency, two or more kinds of sensitizing dye compounds having different photoelectric conversion wavelength ranges can be used in combination. In this case, it is desirable to select the kinds and quantity ratio of the sensitizing dye compounds to be used in combination according to the wavelength range and intensity distribution of irradiation light. Further, the sensitizing dye 31 preferably includes a functional group for bonding to the semiconductor electrode 3. Examples of the functional group include a carboxyl group, a sulfonic group and a cyano group.

The electrode body 32 can be made of a metal oxide material, a metal sulfide material or the like. Examples of the metal oxide material include titanium oxide, tin oxide, zinc oxide and niobium oxide such as niobium pentoxide, tantalum oxide and zirconia. As the metal oxide material, there may also be used double oxide such as strontium titanate, calcium titanate and barium titanate. Examples of the metal sulfide material include zinc sulfide, lead sulfide and bismuth sulfide. Among others, especially preferred is titanium oxide.

The preparation method of the electrode body 32 is not particularly restricted. The electrode body 32 can be prepared by, for example, applying a paste containing fine particles of metal oxide or metal sulfide to a surface of the insulating layer 5 or the first collector electrode 41, and then, sintering the paste. The paste application process is not also particularly restricted and is exemplified by a screen printing process, a doctor blade process, a squeegee process, a spin coat process and the like. The thus-prepared electrode body 32 is in the form of an aggregate in which the fine particles are agglomerated. Alternatively, the electrode body 32 may be prepared by applying a colloid in which fine particles of metal oxide or metal sulfide are dispersed together with a small quantity of organic polymer to the surface of the insulating layer 5 or the first collector electrode 41, and then, removing the organic polymer by heat decomposition.

The colloid can be applied by any process technique such as a screen printing process, a doctor blade process, a squeegee process or a spin coat process. The thus-prepared electrode body 32 is also in the form of an aggregate in which the fine particles are agglomerated.

In this way, the electrode body 32 is generally in fine particle aggregate form. The average diameter of the fine particles, as measured by X-ray diffraction, is not particularly restricted and desirably ranges from 5 to 100 nm, especially 10 to 50 nm.

The thickness of the semiconductor electrode 3 is not particularly restricted and can be adjusted to 0.1 to 100 $\mu$m. It is desirable that the thickness of the semiconductor electrode 3 ranges from 1 to 50 $\mu$m, especially 2 to 40 $\mu$m, more specifically 5 to 30 $\mu$m. When the thickness of the semiconductor electrode 3 is in the range of 0.1 to 100 $\mu$m, it is possible to allow light transmission substantially throughout the semiconductor electrode 3 for improved photoelectric conversion.

Further, the semiconductor electrode 3 is desirably subjected to heat treatment in order to increase the strength of the semiconductor electrode 3 and the adhesion of the semiconductor electrode 3 with the insulating layer 5 or the first collector electrode 41. The temperature and time of the heat treatment are not particularly restricted. It is desirable to control the heat treatment temperature to within 40 to 700°C, especially 100 to 500°C, and to control the heat treatment time to within 10 minutes to 10 hours, especially 20 minutes to 5 hours.

The method of adhering the sensitizing dye 31 to the electrode body 32 is not particularly restricted. The sensitizing dye 31 can be adhered to the electrode body 32 by, for example, immersing the electrode body 32 into a solution in which the sensitizing dye 31 is dissolved with an organic solvent, impregnating the electrode body 32 with the solution, and then, removing the organic solvent. Alternatively, the sensitizing dye 31 may be adhered to the electrode body 32 by applying a solution in which the sensitizing dye 31 is dissolved with an organic solvent to the electrode body 32, and then, removing the organic solvent. The solution application process is herein exemplified by a wire bar process, a slide hopper process, an extrusion process, a curtain coating process, a spin coat process, a spray coat process and the like. The solution can alternatively be applied by a printing process such as an offset printing process, a gravure printing process or a screen printing process.

The adhesion amount of the sensitizing dye 31 preferably ranges from 0.01 to 1 mmol, especially 0.5 to 1 mmol, per 1g of the electrode body of the semiconductor electrode 3. When the adhesion amount of the sensitizing dye 31 is in the range of 0.01 to 1 mmol, the semiconductor electrode 3 is able to attain high photoelectric conversion efficiency. If some of the sensitizing dye 31 exists free around the electrode without being adhered to the electrode body 32, the photoelectric conversion efficiency of the semiconductor electrode 3 may be lowered. It is thus desirable to remove excessive sensitizing dye by washing the electrode body 32 after the process of adhering the sensitizing dye 31 to the electrode body 32. The excessive sensitizing dye can be removed by washing with an organic solvent such as a polar solvent e.g. acetonitrile or an alcohol solvent through the use of a washing bath. In order to adhere a great amount of sensitizing dye to the electrode body 32, the electrode body 32 is preferably subjected to heating before the impregnation or application process. In this case, it is further preferred that the impregnation or application process is performed at temperatures of 40 to 80°C immediately after the heat treatment and before the electrode body 32 reaches an ambient temperature, in order to avoid water from being adsorbed onto a surface of the electrode body 32.

The first collector electrode 41 is arranged on a second surface of the semiconductor electrode 3 so as to receive electrodes from the semiconductor electrode 3 and discharge the electrons out of the solar cell. The material of the first collector electrode 41 can be selected as appropriate. As the material of the first collector electrode 41, metal, conductive oxide and carbon are usable. Examples of the metal include tungsten, titanium, nickel, platinum, gold, copper, aluminum, rhodium and indium. Among others, tungsten is preferred. Examples of the conductive oxide include tin oxide, fluorine-doped tin oxide (FTO), indium oxide, tin-doped indium oxide (ITO) and zinc oxide.

The form of the first collector electrode 41 is not particularly restricted and can be selected as appropriate in such a manner as to allow the first collector electrode 41 to collect electrons from all over the semiconductor electrode 3. For example, the first collector electrode 41 may be provided in sheet form, in linear form (e.g. strip form or bar form) of predetermined pattern or in a combination thereof. The first collector electrode 41 can alternatively be arranged on a different place from the second surface of the semiconductor electrode 3, i.e., on the opposite surface of the semiconductor electrode 3 (facing the light-transmitting substrate 2) or the side surface of the semiconductor electrode 3. As illustrated by an example in FIG. 3, a part or the whole of the first collector electrode 41 may be embedded in the semiconductor electrode 3.

In the case where the first collector electrode 41 is in sheet form, it is required that the first collector electrode 41 be formed into a porous medium in order for the electrolyte material 8 to be distributed between the semiconductor electrode 3 and the catalytic electrode layer 6 for ion migration. The porosity of such a porous medium, as measured by electron microscopic analysis, is not particularly restricted and can range from 2 to 40%, especially 10 to 30%, more especially 15 to 25%. When the porosity of the porous medium is in the range of 10 to 30%, it is possible to distribute the electrolyte material 8 adequately through the porous medium without causing a deterioration in charge collection efficiency.

The first collector electrode 41 in such porous sheet form can be prepared by applying a coating of paste containing a metal component such as tungsten, titanium or nickel and a pore-forming oxide material such as alumina and then sintering the paste coating.

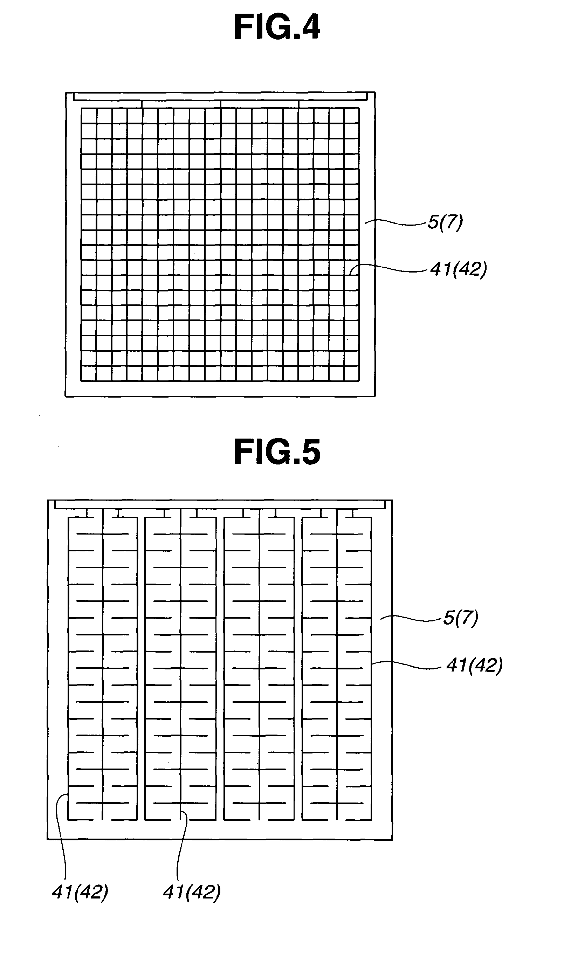

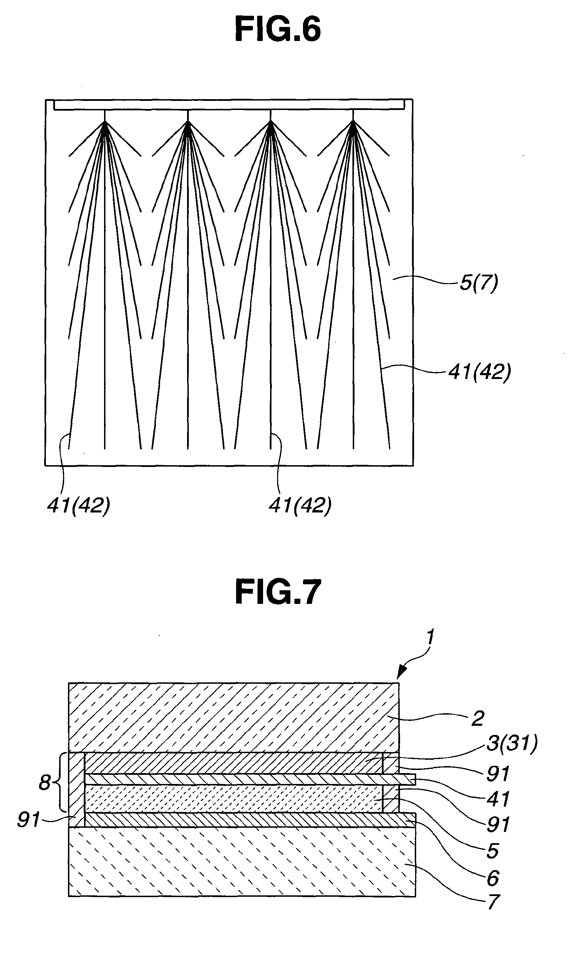

In the case where the first collector electrode 41 is in linear form, the arrangement pattern of the first collector electrode 41 can be selected as appropriate. Examples of the electrode pattern include a grid pattern (see FIG. 4), a comb pattern (see FIG. 5) and a radial pattern (see FIG. 6). The first collector electrode 41 may be formed in a single kind of pattern, or in a combination of a plurality of patterns of the same kind or different kinds. Examples of the grid pattern include those having pattern units in the shapes of triangles (a regular triangle and any other triangles), quadrangles (a regular quadrangle and any other quadrangles), pentagons (a regular pentagon and any other pentagons), hexagons (a regular hexagon and any other hexagons), circles (including an elliptic circle and any other distorted circles) and the like. The width and thickness of the first collector electrode 41 in linear form are not particularly restricted and can be selected as appropriate in view of the electrical resistance, cost and the like.

The preparation method of the first collector electrode 41 in such linear form is not particularly restricted. For example, the first collector electrode 41 can be prepared by depositing a metal e.g. tungsten, titanium or nickel by a physical vapor deposition process such as magnetron sputtering or electron-beam vapor deposition using a mask of predetermined pattern, and then, patterning the deposit by a photolithographic process. Alternatively, the first collector electrode 41 may be prepared by patterning a paste containing a metal component by a screen printing process etc. and sintering the paste. Examples of the metal usable in vapor phase deposition include copper in addition to tungsten, titanium and nickel. Among others, tungsten, titanium and nickel having a high corrosion resistance are preferred as the deposition metal. As the metal contained in the paste, there may also be used tungsten, titanium, nickel and copper. Tungsten, titanium and nickel having a high corrosion resistance are preferred as the paste metal.

There may be additionally provided a second collector electrode 42 on a first surface of the catalytic electrode layer 6 so as to feed electrons into the catalytic electrode layer 6 from the outside of the solar cell. The material of the second collector electrode 42 can be selected as is the case with the material of the first collector electrode 42. The form of the second collector electrode 42 can be selected in such a manner as to allow the second collector electrode 42 to collect electrons from all over the catalytic electrode layer 6. For example, the second collector electrode 42 may be provided in sheet form, in linear form (e.g. strip form or bar form) of predetermined pattern or in a combination thereof. The second collector electrode 42 can alternatively be arranged on a different place from the first surface of the catalytic electrode layer 6, i.e., on the opposite surface of the catalytic electrode layer 6 (facing the substrate 7) or the side surface of the catalytic electrode layer 6. Further, a part or the whole of the second collector electrode 42 can be embedded in the catalytic electrode layer 6. In the case where the second collector electrode 42 is in sheet form, the second collector electrode 42 may or may not be formed into a porous medium without the need for the second collector electrode 42 to distribute therethrough the electrode material 8 in contrast to the first collector electrode 41. In the case where the second collector electrode 42 is in linear form, the arrangement pattern of the second collector electrode 42 can be selected as appropriate as in the case with the first collector electrode 41.

The first collector electrode 41 and the second collector electrode 42 do not necessarily show light-transmitting properties in ordinary cases but may have light-transmitting properties. Each of the first and second collector electrodes 41 and 42, when having a light-transmitting property, can be in the form of a thin film of metal (limited to that which is formable into a thin film), conductive oxide or carbon. Alternatively, the first and second collector electrodes 41 and 42 may be in linear form of predetermined pattern or in a combination of thin-film form and linear form when having light-transmitting properties.

The insulating layer 5 is provided as a separator to prevent the occurrence of inability to obtain power from the dye-sensitized solar cell 1 upon contact of the semiconductor electrode 3 and the first collector electrode 41 with the catalytic electrode layer 6 and the second collector electrode 42 and is formed into a porous medium so as to distribute therethrough the electrolyte material 8.

The material of the insulating layer 5 is not particularly restricted. There may be used ceramic, resin and glass as the material of the insulating layer 5. The insulating layer 5 is desirably formed of ceramic. The kind of the ceramic is not particularly restricted. Various ceramic materials such as oxide ceramic, nitride ceramic and carbide ceramic are usable. Examples of the oxide ceramic include alumina, mullite and zirconia. Examples of the nitride ceramic include silicon nitride, sialon, titanium nitride and aluminum nitride. Examples of the carbide ceramic include silicon carbide, titanium carbide and aluminum carbide. Among others, alumina, silicon nitride and zirconia are preferred. Especially preferred is alumina.

The form of the insulating layer 5 can be selected as appropriate so as to prevent contact of the semiconductor electrode 3 and the first collector electrode 41 with the catalytic electrode layer 6 and the first collector electrode 42. For example, the insulating layer 5 may be provided in sheet form, in linear form (e.g. strip form or bar form) of predetermined pattern or in a combination thereof as is the case with the first collector electrode 41.

When the insulating layer 5 is of a porous medium, the porosity of the insulating layer 5, as measured by electron microscopic analysis, is not particularly restricted and desirably ranges from 2 to 40%, especially 10 to 30%, more especially 15 to 25%. When the porosity of the insulating layer 5 is in the range of 10 to 30%, the electrolyte material 8 can be easily charged and migrated through the insulating layer 5 without impairment of the operation of the solar cell 1.

The thickness of the insulating layer 5 is not particularly restricted and varies depending even on the manufacturing method of the dye-sensitized solar cell 1. In the case of manufacturing the dye-sensitized solar cell 1 by stacking a laminate in which the substrate 7, the catalytic electrode layer 6, the insulating layer 5, the first collector electrode 41 and the semiconductor electrode 3 are laminated together in order of mention onto the light-transmitting substrate 2, the thickness of the insulating layer 5 can be adjusted to 0.5 to 20 $\mu$m, especially 1 to 10 $\mu$m, more especially 2 to 5 $\mu$m. When the thickness of the insulting layer 5 is in the range of 0.5 to 20 $\mu$m in that case, it is possible to establish electrical insulation between the side of the semiconductor electrode 3 and the side of the catalytic electrode layer 6.

The insulating layer 5 can be prepared by applying a paste containing a ceramic component and the like to the surface of the catalytic electrode layer 6 by a screen printing process etc. and sintering the paste for a predetermined time at a predetermined temperature. Alternatively, the insulating layer 5 may be prepared through the deposition of ceramic e.g. alumina, silicon nitride or zirconia onto the surface of the catalytic electrode layer 6 by a physical vapor deposition process such as magnetron sputtering or electron-beam vapor deposition.

The catalytic electrode layer 6 can be made of either a catalytically active material or at least one of metals and conductive oxides and resins containing therein a catalytically active material. Examples of the catalytically active material include noble metals such as platinum and rhodium and carbon black. (Silver is not suitable for use in the catalytic electrode layer 6 due to its low resistance to corrosion by an electrolyte etc. For the same reason, silver is not suitable for use in any portion that may come into contact with an electrolyte etc.) These materials also have conducting properties. It is preferable that the catalytic electrode layer 6 be made of noble metal having catalytic activity and electrochemical stability. Especially preferred is platinum, which has high catalytic activity and is less prone to being dissolved by an electrolytic solution.

In the case of using any of the metals, conductive oxides and conductive resins showing no catalytic activity, the metals usable in the catalytic electrode layer 6 are exemplified by aluminum, copper, chrome, nickel and tungsten and the conductive resins usable in the catalytic electrode layer 6 are exemplified by polyaniline, polypyrrole and polyacethylene. The conductive resins are also exemplified by resin compositions prepared by mixing conductive materials into nonconductive resin materials. The resin material is not particularly restricted and can be either a thermoplastic resin or a thermosetting resin. Examples of the thermoplastic resin include thermoplastic polyester resins, polyamide resins, polyolefin resins and polyvinyl chloride resins. Examples of the thermosetting resin include epoxy resins, thermosetting polyester resins and phenol resins. The conductive material is not also particularly restricted. Examples of the conductive material include carbon black, metals such as copper, aluminum, nickel, chromium and tungsten and conductive polymers such as polyaniline, polypyrrole and polyacetylene. As the conductive materials, especially preferred are noble metal and carbon black each having conductive properties and catalytic activities. These conductive materials can be used solely or in combination thereof. In the case of using any of the metals, conductive oxides and conductive resins showing no catalytic activity, it is further desirable that the catalytically active material be contained in an amount of 1 to 99 parts by mass, especially 50 to 99 parts by mass, per 100 parts by mass of the catalytically inactive metal, conductive oxide and/or conductive resin material.

In this way, the catalytic electrode layer 6 can be prepared from either the catalytically active and electrically conductive material or at least one of the metals, the conductive oxides and the conductive resins containing the catalytically active material. The catalytic electrode layer 6 may be a layer of one kind of material or a mixed layer of two or more kinds of materials. Further, the catalytic electrode layer 6 may have a single layer structure or a multilayer structure including more than one of metal layers, conductive oxide layers, conductive resin layers and mixed layers of two or more of metals, conductive oxides and conductive resins.

The thickness of the catalytic electrode layer 6 is not particularly restricted and can be adjusted to 3 nm to 10 $\mu$m, especially 3 nm to 2 $\mu$m. When the thickness of the catalytic electrode layer 6 is in the range of 3 nm to 10 $\mu$m, it is possible to decrease the resistance of the catalytic electrode layer 6 to a sufficiently low degree.

In the case of the catalytic electrode layer 6 being of the catalytically active material, the catalytic electrode layer 6 can be prepared by applying a paste containing fine particles of the catalytically active material to the surface of the substrate 7 or, when the second collector electrode 42 is provided, to the surface of the second collector electrode 42. In the case of the catalytic electrode layer 6 being of any metal or conductive oxide containing the catalytically active material, the catalytic electrode layer 6 can be prepared in the same manner as in the case of the catalytic electrode layer 6 being of the catalytically active material. The paste application process is exemplified by various process techniques such as a screen printing process, a doctor blade process, a squeegee process and a spin coat process. Alternatively, the catalytic electrode layer 6 may be prepared through the deposition of the metal or the like to the surface of the substrate 7 by a sputtering process, a vapor deposition process, an ion plating process or the like. In the case of the catalytic electrode layer 6 being of the conductive resin containing the catalytically active material, the catalytic electrode layer 6 can be prepared by kneading the conductive resin with the catalytically active material in powdery or fibrous form through the use of a kneading device such as a Banbury mixer, an internal mixer or an open roll, molding the kneaded substance into a film, and then, bonding the film to the surfaces of the substrate 7 and the like. The catalytic electrode layer 6 may alternatively be prepared by dissolving or dispersing the resin composition into a solvent, applying the thus-obtained solution or dispersoid to the surfaces of the substrate 7 and the like, drying to remove the solvent, and then, heating as required. The catalytic electrode layer 6, when being a mixed layer, is prepared by any of the above catalyst layer preparation methods according to the kinds of the material components thereof.

The catalytic electrode layer 6 can be also used as a collector electrode. For example, the function of the collector electrode may be imparted to the catalytic electrode layer 6 by exposing the catalytic electrode layer 6 to the outside in such a manner as to allow a connection of a lead wire etc. to the catalytic electrode layer 6 as shown in FIG. 7.

The substrate 7 may or may not have a light-transmitting property.

The substrate 7 with no light-transmitting property can be made of ceramic, metal, resin or glass.

The substrate 7, when prepared using ceramic, is so high in strength as to function as a supporting substrate and provide the dye-sensitized solar cell 1 with excellent durability. A ceramic material for the ceramic substrate is not particularly restricted. Various ceramic materials such as oxide ceramic, nitride ceramic and carbide ceramic are usable. Examples of the oxide ceramic include alumina, mullite and zirconia. Examples of the nitride ceramic include silicon nitride, sialon, titanium nitride and aluminum nitride. Examples of the carbide ceramic include silicon carbide, titanium carbide and aluminum carbide. As the ceramic material, preferred are aluminum, silicon nitride and zirconia. Alumina is especially preferred.

The substrate 7, when prepared using metal, is also so high in strength as to function as a supporting substrate and provide the dye-sensitized solar cell 1 with excellent durability. The internal resistance of the dye-sensitized solar cell 1 can be lowered by providing the substrate 7' of metal as shown in FIG. 8 and thereby securing high charge collection efficiency owing to the conducting property of the metal substrate 7 in itself even though the second collector electrode 42 is not provided. This substrate metal can be selected as appropriate. Examples of the substrate metal include tungsten, titanium, nickel, noble metals such as platinum and gold and copper.

In the case of the substrate 7 having no light-transmitting property, the thickness of the substrate 7 is not particularly restricted and can be adjusted to 100 $\mu$m to 5 mm, especially 500 $\mu$m to 5 mm, more especially 800 $\mu$m to 5 mm, or 500 $\mu$m to 2 mm. When the thickness of the substrate 7 is in the range of 100 $\mu$m to 5 mm, especially 800 $\mu$m to 5 mm, the substrate 7 is able to attain high strength and function as a supporting substrate so as to provide the dye-sensitized solar cell 1 with excellent durability.

The substrate 7 with a light-transmitting property can be formed of a sheet of glass, resin or the like as in the case of the light-transmitting substrate 2. In the case of the substrate 7 being of the resin sheet, there may be used a thermosetting resin such as polyester, polyphenylene sulfide, polycarbonate, polysulfone and polyethylidene norbornene as the material of the resin sheet.

In the case of the substrate 7 having a light-transmitting property, the substrate 7 varies in thickness depending on the material thereof. The thickness of the substrate 7 is not particularly restricted and is desirably of such a thickness that the above-defined transmissivity ranges from 60 to 99%, especially from 85 to 99%.

The electrolyte material 8 is incorporated in the semiconductor electrode 3, the first collector electrode 41 and the insulating layer 5 so as to allow ion conduction between the semiconductor electrode 3 and the catalytic electrode layer 6. This electrolyte material 8 can be prepared from an electrolyte solution. This electrolyte solution generally contains a solvent and various additives in addition to the electrolyte material 8. Examples of the electrolyte material 8 include: (1) $I_2$ and an iodide; (2) $Br_2$ and a bromide; (3) a metal complex such as a ferrocyanide-ferricyanide complex or a ferrocene-ferricinium ion complex; (4) a sulfur compound such as sodium polysulfide or alkylthiol-alkyldisulfide; (5) a viologen dye; and (6) hydroquinone-quinone. As the iodide of the electrolyte (1), there can be used metal iodides such as LiI, NaI, KI, CsI and CaI$_2$, quaternary ammonium iodides such as tetraalkylammonium iodide, pyridinium iodide and imidazolium iodide and the like. As the bromide of the electrolyte (2), there can be used metal bromides such as LiBr, NaBr, KBr, CsBr and CaBr$_2$, quaternary ammonium bromides such as a tetraalkylammonium bromide and pyridinium bromide and the like. Among these electrolyte materials, especially preferred is a combination of $I_2$ and LiI or the quaternary ammonium iodide such as pyridinium iodide or imidazolium iodide. These electrolyte materials may be used solely or in combination thereof.

The solvent of the electrolyte solution is preferably a solvent having low viscosity, high ionic mobility and sufficient ionic conductance. Examples of such a solvent include: (1) carbonates such as ethylene carbonate and propylene carbonate; (2) heterocyclic compounds such as 3-methyl-2-oxazolidinone; (3) ethers such as dioxane and diethyl ether; (4) chain ethers such as ethylene glycol dialkylethers, propylene glycol dialkylethers, polyethylene glycol dialkylethers and polypropylene glycol dialkylethers; (5) monoalcohols such as methanol, ethanol, ethylene glycol monoalkylethers, propylene glycol monoalkylethers, polyethylene glycol monoalkylethers and polypropylene glycol monoalkylethers; (6) polyalcohols such as ethylene glycol, propylene glycol, polyethylene glycol, polypropylene glycol and glycerin; (7) nitriles such as acetonitrile, glutarodinitrile, methoxyacetonitrile, propionitrile and benzonitrile; and (8) aprotic polar solvents such as dimethylsulfoxide and sulfolane.

Each of one or two or more of the pairs of the light-transmitting substrate 2 and the semiconductor electrode 3, of the first collector electrode 41 and the insulating layer 5 and of the pair of the insulating layer 5 and the catalytic electrode layer 6 may be arranged to have contact or space therebetween in the dye-sensitized solar cell 1 as shown in FIG. 9. When the space between these cell components is filled with the electrolyte material 8 to form an electrolyte layer 81, the solar cell 1 is able to function properly. The electrolyte material 8 may be filled into the whole of the space or be filled into the major portion of the space with the remaining portion of the space left free.

Further, the dye-sensitized solar cell 1 has a seal 91 between circumferences of the light-transmitting substrate 2 and the substrate 7 so as to avoid a loss of electrolyte material 8. The seal 91 can be formed of a resin or the like. Examples of the resin include thermosetting resins such as epoxy resins, urethane resins, polyimide resins and thermosetting resins such as thermosetting polyester resins. The seal 91 may alternatively be formed of glass. It is desirable that the seal 91 be of glass especially when the solar cell requires long-term durability.

As described above, there is no need in the dye-sensitized solar cell 1 to provide a light-transmitting collector electrode to the light-transmitting substrate 2 on the light incident side. It is therefore possible to lower the internal resistance of the dye-sensitized solar cell 1 with the use of the collector electrode 41 of metal having a light shielding property and low resistance. It is also possible to irradiating a large amount of light on the semiconductor electrode 3 and improve the photoelectric conversion efficiency of the dye-sensitized solar cell 1 without the light amount being reduced by such a light-transmitting collector electrode.

When the substrate 7 is made of ceramic, the substrate 7 functions as a supporting substrate. The dye-sensitized solar cell 1 is thus able to attain excellent durability.

When the semiconductor electrode 3 is made of titanium oxide, the dye-sensitized solar cell 1 is able to obtain an improvement in photoelectric conversion efficiency.

When the first collector electrode 41 is of a porous medium layer, the first collector electrode 41 allows the electrolyte material 8 to pass therethrough to the catalytic electrode layer 6 adequately. The first collector electrode 41 also allows the electrolyte material 8 to pass therethrough to the catalytic electrode layer 6 adequately, while attaining an improvement in photoelectric conversion efficiency, when the planar configuration of the first collector electrode 41 is in a grid pattern, a comb pattern or a radial pattern.

The dye-sensitized solar cell 1 is made lower in internal resistance in the case of the second collector electrode 42 being provided between the substrate 7 and the catalytic electrode layer 6. When the planar configuration of the second collector electrode 42 is in sheet form or in a grid pattern, a comb pattern or a radial pattern, the dye-sensitized solar cell 1 is able to obtain an improvement in photoelectric conversion efficiency. The dye-sensitized solar cell 1 is able to obtain a further improvement in photoelectric conversion efficiency especially when the second collector electrode 42 is in sheet form.

EXAMPLES

The present invention will be described in more detail with reference to the following examples of the dye-sensitized solar cell 1. It should be however noted that the following examples are only illustrative and not intended to limit the invention thereto.

Example 1

In Example 1, a dye-sensitized solar cell 1 was manufactured by laminating solar cell components successively from the side of a substrate 7 by the following procedures.

(1) Production of Sintered Laminate

A slurry was prepared by mixing 100 parts by mass of an aluminum powder of 99.9 mass% purity with 5 parts by mass of a mixed powder of magnesia, calcia and silica as a sintering aid, 2 parts by mass of a binder and a solvent. Using this slurry, an alumina green sheet for a substrate 7 having a length of 100 mm, a width of 100 mm and a thickness of 2 mm was produced by a doctor blade process. Next, a conductive film for a second collector electrode 42 was provided on a surface of the alumina green sheet through the application of a paste containing tungsten particles of 1 to 10 $\mu$m in diameter by a screen printing process. A conductive film for a catalytic electrode layer 6 having a thickness of 500 nm was provided on a surface of the above-applied conductive film by a screen printing process using a platinum-containing metalized ink. An alumina green sheet for an insulating layer 5 was further formed through the application of the alumina slurry by a screen printing process. Then, a conductive film for a first collector electrode 41 was provided on the aluminum green sheet layer through the application of the same tungsten-containing paste as above by a screen printing process. The thus-obtained green laminate was integrally sintered at 1500°C in a reducing atmosphere, thereby yielding a sintered laminate.

(2) Production of Semiconductor Electrode 3

A titanium electrode layer (as an electrode body 32) having a length of 90 mm, a width of 90 mm and a thickness of 20 $\mu$m was formed on a surface of the sintered laminate located on the side of the catalytic electrode layer 6, by applying a paste containing titania particles by a screen printing process, drying at 120°C for 1 hour and sintering at 480°C for 30 minutes. The laminate was then immersed in an ethanol solution of ruthenium complex (available under the trade name of "535bis-TBA" from Solaronix) for 10 hours, so as to adhere the ruthenium complex as a sensitizing dye 31 having a light absorption wavelength of 400 to 600 nm to the sintered titanium particles as partly enlarged in FIG. 2 and thereby complete a semiconductor electrode 3.

(3) Sealing of Electrolyte Material 8

A thermoplastic adhesive sheet, for a joint 91, having a thickness of 60 $\mu$m (available under the trade name of "SX 1170-60" from Solaronix) was provided at a location on a surface of the alumina substrate 7 of the sintered laminate on which the catalytic electrode layer 6 and the like had been formed and around the catalytic electrode layer 6. After that, a soda glass substrate (as a light-transmitting substrate 2) having a length of 100 mm, a width of 100 mm and a thickness of 1 mm was arranged in such a manner as to face the semiconductor electrode 3. The thus-obtained laminate was placed on a hot plate whose temperature had been adjusted to 100°C, with the alumina substrate 7 being directed downward, and heated for 5 minutes. The joint 91 was established between the soda glass substrate 2 and the alumina substrate 7 by heating. An electrolyte material 8 was incorporated into the semiconductor electrode 3, the first collector electrode 41 and the insulating layer 5 by injecting an iodine electrolytic solution (available under the trade name of "Iodolyte PN-50" from Solaronix) through unjoined electrolyte solution injection holes. The injected iodine electrolytic solution was filled into structural voids in the first collector electrode 41 and the insulating layer 5 and migrated to reach the surface of the catalytic electrode layer 6. After that, the injection holes were sealed with the same adhesive as above. The dye-sensitized solar cell 1 shown in FIG. 1 was then completed.

(4) Performance Evaluation of Dye-sensitized Solar Cell 1

Artificial sunlight was irradiated onto the dye-sensitized solar cell 1 produced by the above procedures (1) to (3) with an intensity of 100 mW/cm$^2$ by means of a solar simulator whose spectrum had been adjusted to AM 1.5. The dye-sensitized solar cell 1 characteristically showed a conversion efficiency of 6.8%.

Example 2

In Example 2, a dye-sensitized solar cell 1 having a first collector electrode 41 in a grid pattern was manufactured by the following procedures.

(1) Production of Sintered Laminate

An alumina green sheet for a substrate 7 having a length 100 mm, a width of 100 mm and a thickness of 2 mm was prepared in the same manner as in Example 1. A conductive film for a second collector electrode 42 was provided on a surface of the alumina green sheet through the application of the same tungsten-containing paste as above by a screen printing process. A conductive film for a catalytic electrode layer 6 having a thickness of 500 nm was provided on a surface of the above-applied conductive film by a screen printing process using a platinum-containing metalized ink. An alumina green sheet for an insulating layer 5 was further formed through the application of the alumina slurry by a screen printing process. Then, a conductive film for a first collector electrode 41 was provided on the aluminum green sheet layer through the application of the same tungsten-containing paste as above by a screen printing process. Herein, the conductive film had a grid pattern of substantially regular quadrangle pattern units with an opening rate of 20%. The thus-obtained green laminate was integrally sintered at 1500°C in a reducing atmosphere, thereby yielding a sintered laminate.

(2) Production of Semiconductor Electrode 3

A semiconductor electrode 3 was produced in the same manner as in Example 1.

(3) Sealing of Electrolyte Material 8

The dye-sensitized solar cell 1 was completed by providing a joint 91 and then sealing an electrolyte material 8 in the same manner as in Example 1.

(4) Performance Evaluation of Dye-sensitized Solar Cell 1

Artificial sunlight was irradiated onto the dye-sensitized solar cell 1 produced by the above procedures (1) to (3) with an intensity of 100 mW/cm$^2$ by means of a solar simulator whose spectrum had been adjusted to AM 1.5. The dye-sensitized solar cell 1 characteristically showed a conversion efficiency of 8.0%. The evaluation result of Example 2 was as favorable as that of Example 1.

Comparative Example

In Comparative Example, a dye-sensitized solar cell having a light-transmitting conductive layer 43 arranged on a light-transmitting substrate 2, as shown in FIG. 10, was manufactured by the following procedures.

(1) Production of Sintered Laminate

An alumina green sheet for a substrate 7 having a length of 100 mm, a width of 100 mm and a thickness of 2 mm was prepared in the same manner as in Example 1. Next, a conductive film for a second collector electrode 42 was provided on a surface of the alumina green sheet through the application of the same tungsten-containing paste as above by a screen printing process. A conductive film for a catalytic electrode layer 6 having a thickness of 500 nm was then provided on a surface of the above-applied conductive film by a screen printing process using a platinum-containing metalized ink. The thus-obtained green laminate was integrally sintered at 1500°C in a reducing atmosphere, thereby yielding a sintered laminate.

(2) Production of Laminate with Light-Transmitting Substrate

A glass substrate having a length of 100 mm, a width of 100 mm and a thickness of 1 mm was prepared as a light-transmitting substrate 2. A light-transmitting conductive layer 43 of fluorine-doped tin oxide having a thickness of 500 nm was provided on a surface of the substrate 2 by a RF sputtering process. A titanium electrode layer (as an electrode body) was subsequently formed on a surface of the light-transmitting conductive layer 43 by applying the same titania-containing paste as above by screen printing, drying at 120°C for 1 hour and sintering at 480°C for 30 minutes. A semiconductor electrode 3 was then completed by immersing the laminate in the same ruthenium complex ethanol solution as above for 10 hours and thereby adhering a ruthenium complex sensitizing dye 31 to the electrode layer.

(3) Manufacturing of Dye-sensitized Solar Cell

The same adhesive sheet as above was provided to a surface portion of the alumina substrate 7 of the sintered laminate on which the catalytic electrode layer 6 had not been formed. The light-transmitting substrate laminate was arranged in such a manner that the semiconductor electrode 3 and the catalytic electrode layer 6 faced each other. The thus-obtained laminate was placed on a hot plate whose temperature had been adjusted to 100°C, with the alumina substrate 7 being directed downward, and heated for 5 minutes to form a joint 91 between the light-transmitting substrate 2 and the aluminum substrate 7. The same iodine electrolytic solution as above was injected through unjoined injection holes. After that, the injection holes were sealed with the same adhesive as above. The dye-sensitized solar cell shown in FIG. 10 was then completed.

(4) Comparisons with Examples

The performance of the dye-sensitized solar cell of Comparative Example was evaluated in the same manner as in Example 1. The solar cell of Comparative Example showed a conversion efficiency of 6.2%. It is thus obvious that the solar cell of Comparative Example was lower in performance than those of Examples 1 and 2.

Although the present invention has been described with reference to the specific embodiments of the invention, the invention is not limited to the above-described embodiments. Various modification and variation of the embodiments described above will occur to those skilled in the art in light of the above teaching. For example, there may alternatively be used, as the electrolyte material 8, an ionic liquid of nonvolatile imidazolium salt, a gelated product thereof or a solid such as copper iodide or copper thiocyanate. Although the first collector electrode 41, the insulating layer 5 and the second collector electrode 42 are made porous in the above examples, the first collector electrode 41, the insulating layer 5 and the second collector electrode 42 are not limited to those of the above examples. As shown in FIGS. 4 to 6, each of the first collector electrode 41, the insulating layer 5 and the second collector electrode 42 may be provided in a line pattern.

**Claims**

1. A dye-sensitized solar cell, comprising:

   a first substrate having a light-transmitting property;
   a semiconductor electrode containing a sensitizing dye and arranged in such a manner that a first surface of the semiconductor electrode faces the first substrate;
   a first collector electrode arranged on a second surface of the semiconductor electrode;
   an insulating layer arranged in contact with the first collector electrode;
   a catalytic electrode layer arranged in such a manner that a first surface of the catalytic electrode layer faces the insulating layer;
   a second substrate arranged on a second surface of the catalytic electrode layer; and
   an electrolyte material incorporated in the semiconductor electrode, the first collector electrode and the insulating layer.

2. The dye-sensitized solar cell according to claim 1, wherein the second substrate is made of ceramic and/or metal.

3. The dye-sensitized solar cell according to claim 1 or 2, wherein the semiconductor electrode is prepared from titanium oxide.

4. The dye-sensitized solar cell according to any one of claims 1 to 3, wherein the first collector electrode is in the form of a porous layer.

5. The dye-sensitized solar cell according to any one of claims 1 to 3, wherein the first collector electrode has a planar configuration in a grid pattern, comb pattern or radial pattern.

**6.** The dye-sensitized solar cell according to any one of claims 1 to 5, further comprising a second collector electrode between the second substrate and the catalytic electrode layer.

**7.** The dye-sensitized solar cell according to claim 6, wherein the second collector electrode has a planar configuration in a sheet form or in a grid pattern, a comb pattern or a radial pattern.

# FIG.1

# FIG.2

# FIG.3

# FIG.4

5(7)

41(42)

# FIG.5

5(7)

41(42)

41(42)          41(42)

# FIG.6

5(7)

41(42)

41(42)        41(42)

# FIG.7

1

2

3(31)

91

8 {

41

91

91

5

6

7

# FIG.8

# FIG.9

# FIG.10

**INTERNATIONAL SEARCH REPORT**

| International application No. |
| --- |
| PCT/JP2004/016316 |

**A. CLASSIFICATION OF SUBJECT MATTER**
Int.Cl$^7$ H01M14/00, H01L31/04

According to International Patent Classification (IPC) or to both national classification and IPC

**B. FIELDS SEARCHED**

Minimum documentation searched (classification system followed by classification symbols)
Int.Cl$^7$ H01M14/00, H01L31/04

Documentation searched other than minimum documentation to the extent that such documents are included in the fields searched

| | | | |
| --- | --- | --- | --- |
| Jitsuyo Shinan Koho | 1926–1996 | Toroku Jitsuyo Shinan Koho | 1994–2004 |
| Kokai Jitsuyo Shinan Koho | 1971–2004 | Jitsuyo Shinan Toroku Koho | 1996–2004 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| Y | JP 2001-283941 A (Hitachi Maxell, Ltd.), 12 October, 2001 (12.10.01), Claims 1 to 6; full description, drawings (Family: none) | 1-7 |
| Y | JP 2000-243465 A (Aisin Seiki Co., Ltd.), 08 September, 2000 (08.09.00), Claims 1, 2; examples; drawings (Family: none) | 1-7 |
| Y | JP 2002-367686 A (Aisin Seiki Co., Ltd.), 20 December, 2002 (20.12.02), Claims 1 to 14; examples (Family: none) | 1-7 |

| ☒ | Further documents are listed in the continuation of Box C. | ☐ | See patent family annex. |
| --- | --- | --- | --- |

| | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search 04 January, 2005 (04.01.05) | Date of mailing of the international search report 25 January, 2005 (25.01.05) |
| --- | --- |
| Name and mailing address of the ISA/ Japanese Patent Office | Authorized officer |
| Facsimile No. | Telephone No. |

Form PCT/ISA/210 (second sheet) (January 2004)

( .

**INTERNATIONAL SEARCH REPORT**

| International application No. |
| --- |
| PCT/JP2004/016316 |

C (Continuation).  DOCUMENTS CONSIDERED TO BE RELEVANT

| Category* | Citation of document, with indication, where appropriate, of the relevant passages | Relevant to claim No. |
| --- | --- | --- |
| Y | JP 2002-313443 A  (Aisin Seiki Co., Ltd.), 25 October, 2002 (25.10.02), Claims 1 to 5; examples (Family: none) | 1-7 |
| Y | JP 2002-170602 A  (Hitachi Maxell, Ltd.), 14 June, 2002 (14.06.02), Claims 1 to 15; examples (Family: none) | 1-7 |
| Y | JP 2001-345125 A  (Hitachi Maxell, Ltd.), 14 December, 2001 (14.12.01), Claims 1 to 26; examples (Family: none) | 1-7 |
| A | JP 2002-94096 A  (Canon Inc.), 29 March, 2002 (29.03.02), Claims 1 to 9; examples (Family: none) | 1-7 |
| P,A | JP 2004-319383 A  (Sharp Corp.), 11 November, 2004 (11.11.04), Claims 1 to 7; examples (Family: none) | 1-7 |

Form PCT/ISA/210 (continuation of second sheet) (January 2004)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 1220380 A

**Non-patent literature cited in the description**

- *Nature,* 1991, vol. 353, 737-740